# EUROPEAN PATENT APPLICATION

(11) **EP 2 200 410 A1**
(43) Date of publication of application: **23.06.2010**
(21) Application number: 09011519.7
(22) Date of filing: 08.09.2009
(51) Int. Cl.: H05K 1/09

(54) **A preparing method for printed circuit boards by directing printing and printed circuit boards prepared by the method**

(30) Priority: 05.12.2008 KR 20080122951
(71) Applicant: Exax Inc., Gumi-si, Kyungsangbuk-do 730-906 (KR)
(72) Inventor: Heo, Soon Yeong, Cheonan-si Chungcheongnam-do (KR); Park, Seong Sil, Cheonan-si Chungcheongnam-do (KR)
(74) Representative: advotec.

(57) **Abstract**

The present invention provides a method of preparing printed circuit boards (PCB) or flexible printed circuit boards (FPCB) by direct printing comprising: 1) a step of printing a pattern on substrate with a paste composition including conductive particles, polyamic acid as binder and solvent; 2) a step of baking the printed substrate to imidize the polyamic acid; and 3) a step of electro-plating the printed substrate. The present invention also provides printed circuit boards (PCB) or flexible printed circuit boards (FPCB) prepared by the method.

According to the present invention, printed circuit boards (PCB) or flexible printed circuit boards (FPCB) are produced by applying an addition method of direct printing while to simplify processes, to save time and cost, and to minimize waste.

## Description

### DETAILED DESCRIPTION

### TECHNICAL FIELD

The present invention is directed to a method of preparing printed circuit boards(PCB) or flexible printed circuit boards (FPCB) by direct printing on substrate using a paste composition. The present invention is also directed to printed circuit boards(PCB) or flexible printed circuit boards (FPCB) prepared by the method.

### TECHNICAL BACKGROUND

A PCB or a FPCB is the most basic electronic component with various components soldered or mounted on to function a device. A PCB or a FPCB is manufactured to have certain patterns or circuits by etching a copper clad laminate (CCL) or a flexible copper clad laminate (FCCL) respectively. A method of patterning through etching is called a 'subtractive method'.

On the other hand, researches and efforts have been made to apply an additive method by direct printing for relatively simple pattern forming in displays including a liquid crystal display (LCD) and a plasma display panel (PDP), touch panels, RFID, shields against electromagnetic waves and so on instead of a subtractive method by etching which causes complexities in processes and a great quantity of waste to be treated after processes. To enlarge the scope of the above-mentioned efforts, manufacturing economically PCB or FPCB by printing directly conductive patterns on a board has been attempted to avoid complexities and waste problems of subtractive methods. However, since on PCB or FPCB is mounted or soldered many components, manufacture of PCB or FPCB by direct printing still has many problems to overcome such as heat-resistance, adhesive strength and solderabilty besides conductivity. For example, Korean patent preliminary publication No. 10-2008-0013207 discloses that electrically conductive patterns are formed by direct printing using silver paste mainly consisting of silver ammonium carbamate and binder, and then metal is electro-plated on the patterns to achieve metal patterns with low resistance. Such conductive patterns have basic problems in adhesive strength and heat-resistance, and cannot tolerate soldering to mount components on them.

### DISCLOSURE

### TECHNICAL PROBLEM

An object of the present invention is to provide a method of preparing printed circuit boards (PCB) or flexible printed circuit boards (FPCB) by direct printing.

Another object of the present invention is to provide a method of preparing printed circuit boards (PCB) or flexible printed circuit boards (FPCB) having both sides or mutilple layers by direct printing.

Another object of the present invention is to provide flexible boards having printed antenna bondable with Rfid chip.

The other object of the present invention is to provide a printed circuit board (PCB) or a flexible printed circuit board (FPCB) wherein the circuit is formed by direct printing.

### TECHNICAL SOLUTION

According to the present invention, there is provided a method of preparing printed circuit boards (PCB) or flexible printed circuit boards (FPCB) by direct printing comprising:
1) a step of printing a pattern on substrate with a paste composition including conductive particles, polyamic acid as binder and solvent;
2) a step of baking the printed substrate to imidize the polyamic acid; and
3) a step of electro-plating the printed substrate.

According to the present invention, there is also provided a printed circuit board (PCB) or a flexible printed circuit board (FPCB) having multiple layers further repeatedly comprising a step of printing an insulating pattern and the steps 1) through 3).

According to the present invention, there is also provided a printed circuit board (PCB) or a flexible printed circuit board (FPCB) having both faces and conductive via holes or through holes further comprising a step of making holes in the substrate and the steps 1) through 3) on the other side of the substrate.

According to the present invention, there is also provided a printed circuit board (PCB) or a flexible printed circuit board (FPCB) having a single layer, multiple layers or both sides by direct printing according to the methods mentioned above.

The "circuit" in "printed circuit board (PCB)" or "flexible printed circuit board" means electrically conductive pattern including antenna and circuit.

The paste composition preferably consists of 0.01 to 96 w% of conductive particles, 0.5 to 96 w% of polyamic acid and residual solvent. The paste composition, if necessary, may further comprise metal precursor. The polyamic acid is preferably defined as Formula 1 below. 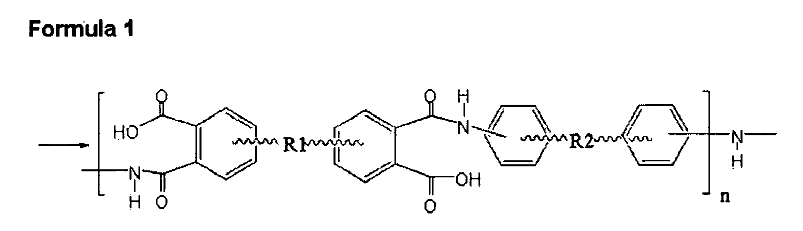 R1 and R2 are respectively a hydrocarbon chain or a hetero-atomic chain having N, O and/or S, or indicate a bridge or fusion between benzene rings. R1 and R2 are respectively, for example, CO-, -SO₂-, -CH₂-, -C₂H₄-, -C₃H₆- or -O-.

The polyamic acid is obtained by polyaddition of aromatic diacid anhydride defined as formula 2 below and aromatic diamine defined as formula 3 below. As a solvent, for example, N,N-dimethylformamide("DMF"), N,N-dimethylacetamide("DMAc"), N-methylpyrrolidone("NMP"), tetramethylurea("TMU"), dimethylsulfoxide("DMSO") or mixture thereof is used to dissolve or to disperse the aromatic diacid anhydride and/or the aromatic diamine. In the present invention, "solvent" means broadly medium inclusive of solvent and dispersion medium and "solution" is used to include dispersion as a case may be. The polyamic acid binder is prepared by mixing a solution of the aromatic diacid anhydride and a solution of the aromatic diamine. The solvent for the solution of the aromatic diacid anhydride is preferably the same as that of the aromatic diamine and imported as solvent for the resultant binder without separation. 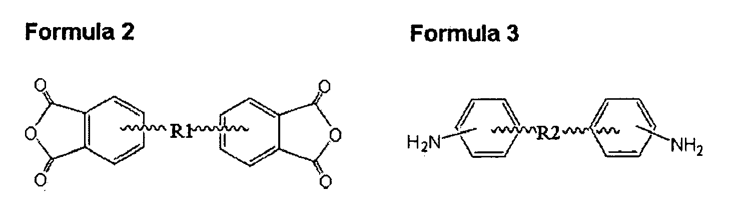 R1 and R2 are respectively a hydrocarbon chain or a hetero-atomic chain having N, O and/or S, or indicate a bridge or fusion between benzene rings.

The aromatic diacid anhydride defined as formula 2 above is, for example, 1,2,4,5-benzentetracarboxylic dianhydride, 3,3', 4,4'-benzophenonetetracarboxylic dianhydride ("BTDA"), oxydiphthalic anhydride("ODPA"), 3,3', 4,4'-diphenylsulfonetetracarboxylic anhydride("DSDA"), biphenyltetracarboxylic dianhydride("BPDA"), 3-hydroquinone-o,o' -diacetic anhydride("HQDA") or 2,2-bis[4-3,4-dicarboxyphenoxylphenyl]propane dianhydride("BPADA").

The aromatic diamine defined as formula 3 above is, for example, m-phenylenediamine, p-phenylenediamine, oxydianiline, 4,4'-diaminodiphenylsulfone or 4,4'-diaminobenzophenone.

Herein, "conductive particles" mean particles of electrically conductive material. The material has no limitation as long as it has electric conductivity as solid state. The material is metal or nonmetal, oxides, carbides, borides, nitrides or carbonitrides thereof inclusive of carboneous particle such as carbon black and graphite. Conductive particles are, for example, particles of gold, aluminum, copper, indium, antimony, magnesium, chrome, tin, nickel, silver, iron, titanium and alloys thereof, and oxides, carbides, borides, nitrides or carbonitrides thereof. As carboneous particles, there are, for example, natural graphite flake, expanded graphite, graphene, carbon black, nano-carbon and carbon nanotube. The shape of particles, not specially restricted, is, for example, plain, fibrous or nano-sized. Such particles may be used solely or in combination.

Herein, metal precursor means organo-metallic compound wherein metal is bonded to organic material through hetero atoms such as P, S, O and N and which is metalized at temperatures much lower than the melting point of the corresponding metal. Such organo-metal includes, for example, metal bonded to a ketone, a mercapto, a carboxyl, an aniline, an ether or a thiosulfate group.

Direct printing includes brushing, spraying, roller coating, screen printing, gravure printing, offset printing, flexography, dispensing, rotary screen printing and inkjet printing.

Besides stiff boards, various flexible substrate such as paper, polyester film and polyimide film can be used in the present invention.

In the present invention, the printed pattern may be dried at a higher or an ambient temperature, and then is heat-treated or baked desirably between 150 °C to 350 °C to imidize the polyamic acid at the step 2). Heat-treating for metallization can be carried out separately from or simultaneously with that for the imidization in the range of the temperature, when metal precursor is used in the paste. The paste is fixed on the substrate since metal precursor is metalized and polyamic acid binder is ring-closed through such heat-treating. The imidized binder resists above 400 °C.

According to the present invention, a printed circuit board (PCB) or a flexible printed circuit board (FPCB) having multiple layers or both sides is easily prepared. Via-holes and through-holes are formed through the substrate for PCB or FPCB having both sides or through the insulating layer for PCB or FPCB having multiple layers. A conductive pattern to conduct via holes or through holes may be printed, aside from or together with the second layer of circuit. On any cases, both sides and multiple layers of circuits are obtained only by several printings.

### ADVANTAGEOUS EFFECT

The present invention can prepare printed circuit boards (PCB) or flexible printed circuit boards (FPCB) by applying an addition method of direct printing while to simplify processes, to save time and cost, and to minimize waste.

### DESCRIPTION OF DRAWINGS

Figure 1 is a photograph showing a pattern formed in Preparative Example 1.
Figure 2 is a photograph showing printed circuits on polyimide film in Example 1 and its partial enlargement view.
Figure 3 is a photograph showing electro-plated printed circuits on polyimide film in Example 1 and its partial enlargement view.
Figure 4 is a chart showing schematically the process of manufacturing FPCB having multiple layers of circuits.
Figure 5 is a chart showing schematically the process of manufacturing FPCB having both sides of circuits.
Figure 6 is a photograph showing printed antenna on polyimide film in Example 4.

### MODE FOR INVENTION

Hereinafter, examples are described in detail, but the scope of the present invention should not be construed to be limited by the examples. Various alternatives or modifications would be possible while they would be within the scope of the present invention.

### Preparative Examples 1 to 7

### Preparation of binder

19.2 g of 4, 4'-diaminodiphenyl ether("ODA") is dissolved in 80g of N-methylpyrrolidone to prepare ODA solution. 20.9 g of pyromellitic dianhydride ("PMDA") is dispersed in 80g of N-methylpyrrolidone to prepare PMDA dispersion. The PMDA dispersion is added dropwise to the ODA solution for 2 hours. The mixture is reacted for 24 hours by agitating at room temperature to prepare polyamic acid binder.

### Preparation of paste

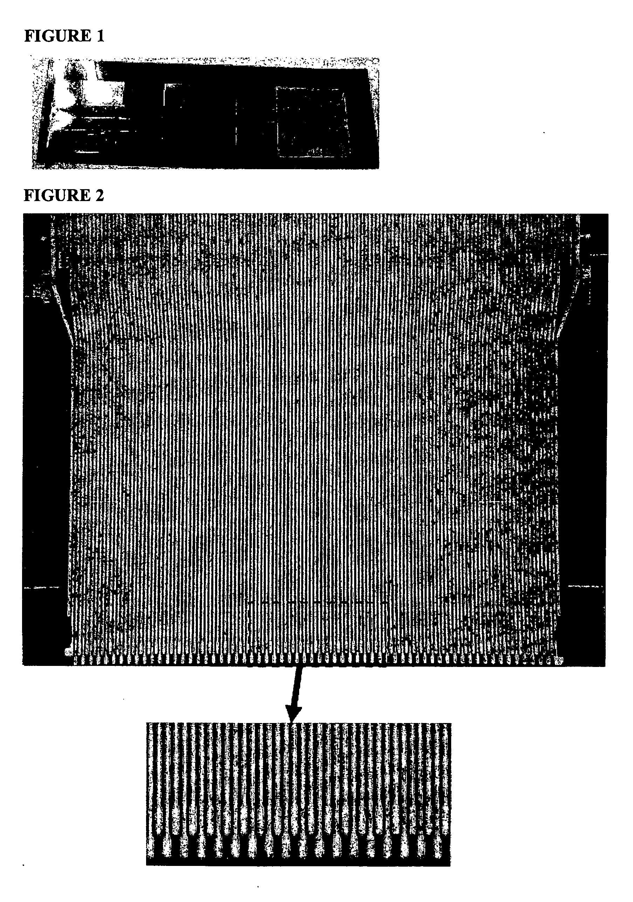

150 to 210 g of plate-like(the diameter is 50 times of the thickness) silver powder having an average particle size of 2 µm, 0 to 30 g of N-methylpyrrolidone and 60 to 150 g of the polyamic acid binder prepared above are thoroughly mixed together according to the proportions as shown in Table 1 to prepare silver pastes. On polyimide film, a pattern is printed as shown in Figure 1 by a screen printer using the silver pastes as ink. The printing including the film is baked for about 10 minutes at 200 °C to get rid of volatile organic compounds and to imidize the polyamic acid binder. Surface resistance, adhesion, hardness and stability under heat of the pattern formed were measured and indicated Table 2. The surface resistances according to Examples were indicated as a graph in Table 3. Surface resistance is measured by 4-probe method, adhesion force by tape method(ASTM-D3359B) and hardness by pencil-hardness-test(ASTM-D3369). Stability under heat for pastes is rated by observing melting and deformation under heating and soldering as follows:
⊚; excellent, no deformation when touched for I minute with iron heated at 400 °C
○; good, no deformation after soldering with iron
Δ; ordinary, no deformation after 30 minutes in a oven sustaining at 280 °C, but
deformation after soldering with iron
×; deformation after 30 minutes in a oven sustaining at 280 °C

**Table 1**

| Preparative Example | Paste No. | PAA Binder(g) | NMP(g) | Ag powder(g) |
|---|---|---|---|---|
| 1 | AP-A | 60 | 30 | 210 |
| 2 | AP-B | 75 | 15 | 210 |
| 3 | AP-C | 90 | - | 210 |
| 4 | AP-D | 105 | - | 195 |
| 5 | AP-E | 120 | - | 180 |
| 6 | AP-F | 135 | - | 165 |
| 7 | AP-G | 150 | - | 150 |

**Table 2**

| Preparative Example | Paste No. | Surface Resistance (× 10⁻² O/□) | Adhesion Test | Hardness | Stability under Heat |
|---|---|---|---|---|---|
| 1 | AP-A | 4.094 | 5B | 5H | ○ |
| 2 | AP-B | 3.428 | 5B | 5H | ○ |
| 3 | AP-C | 2.287 | 5B | 5H | ⊚ |
| 4 | AP-D | 3.512 | 5B | 5H | ⊚ |
| 5 | AP-E | 5.254 | 5B | 5H | ⊚ |
| 6 | AP-F | 7.882 | 5B | 5H | ⊚ |
| 7 | AP-G | 9.883 | 5B | 5H | ⊚ |

| | | | | | |
|---|---|---|---|---|---|
| ⊚ very excellent, ○ excellent, Δ ordinary, × bad | | | | | |

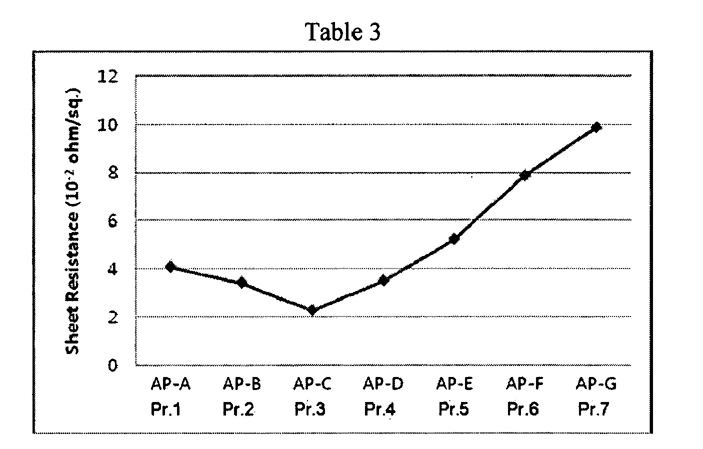

### Example 1

On polyimide film, a circuit pattern is printed as shown in Figure 2 by a screen printer using the silver pastes prepared in Preparative Example 5 as ink. The printing including the film is baked for about 10 minutes at 200 °C to get rid of volatile organic compounds and to imidize the polyamic acid binder.

220 weight part of copper sulfate is dissolved in 600 weight part of pure water. 2 weight part of active carbon is added to the solution which is then agitated for 3 hours and filtered. The filtrate is agitated after 66 weight part of sulfuric acid, 10 weight part of 5007-MU, 0.5 weight part of 5000-A and 0.5 weight part of 5007-B (manufactured by IBC) as bath drying agents are added to the solution. 1000 ml of final plating bath is obtained after 0.00166 weight part of sodium chloride and residual pure water is added.

Copper is plated on the circuit pattern in the plating bath by contacting the circuit pattern to a cathode and applying 0.5∼5A/dm² for 1 to 30 minutes.

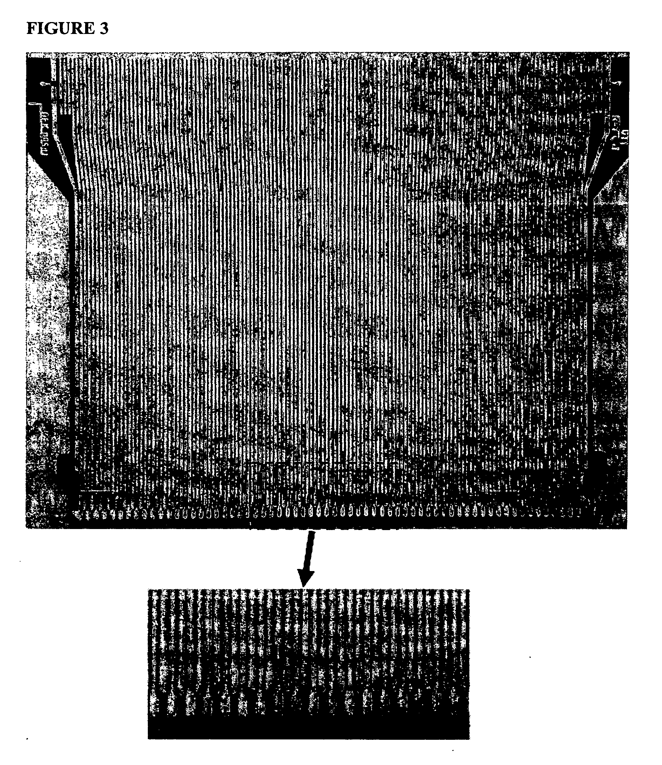

Multi-layered ceramic condenser was soldered on the plated circuit by iron at 400 °C. The adhesion was measured 0.9 kg_{f} as peel strength using a tensile strength tester. The plated circuit is shown in Figure 3.

### Example 2

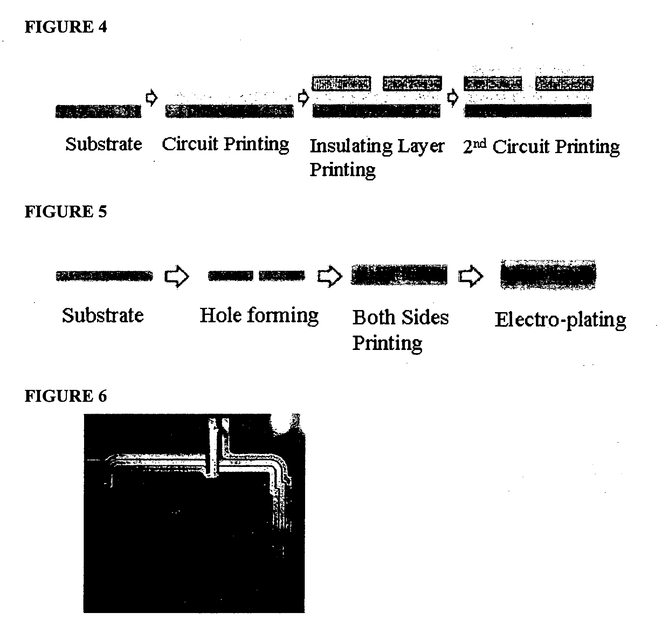

On the flexible circuit board prepared according Example 1, an insulating layer is printed and baked. A second layer of circuit is printed on the insulating layer in the same way as the first layer of circuit. A conductive pattern to conduct via holes aside from the second layer of circuit via holes may be printed. The printing including the film is baked for about 10 minutes at 200 °C to imidize the polyamic acid, and is electro-plated as Example 1. The process is illustrated in Figure 4.

Multi-layered ceramic condenser was soldered on the plated circuit by iron at 400°C. The adhesion is measured 0.85 kg_{f} by a tensile strength tester.

### Example 3

On the other face of the flexible circuit board prepared according Example 1, a second layer of circuit is printed on the substrate in the same way as the first layer of circuit. A conductive pattern to conduct via holes aside from the second layer of circuit via holes may be printed. The printing including the film is baked for about 10 minutes at 200 °C to imidize the polyamic acid binder, and is electro-plated as Example 1. The process is illustrated in Figure 5.

Multi-layered ceramic condenser was soldered on the plated circuit by iron at 400°C. The adhesion is measured 0.91 kg_{f} by a tensile strength tester.

### Example 4

On polyimide film, a loop antenna for mobile phone is printed as shown in Figure 6 by a screen printer using the silver pastes prepared in Preparative Example 5 as ink. The printing including the film is baked for about 10 minutes at 200 °C to imidize the polyamic acid binder. The printing is electro-plated as Example 1.
Multi-layered ceramic condenser was soldered on the plated circuit by iron at 400 °C. The adhesion is measured 1.1 kg_{f} by a tensile strength tester.

## Claims

1. A method of preparing printed circuit boards (PCB) or flexible printed circuit boards (FPCB) by direct printing comprising:
1) a step of printing a pattern on substrate with a paste composition including conductive particles, polyamic acid as binder and solvent;
2) a step of baking the printed substrate to imidize the polyamic acid; and
3) a step of electro-plating the printed substrate.

2. The method according to Claim 1, wherein the step of printing is carried out by spraying, roller coating, screen printing, gravure printing, offset printing, flexography, dispensing, rotary screen printing or inkjet printing.

3. The method according to Claim 2, wherein the substrate is paper, polyester film or polyimide film.

4. The method according to Claim 1, of preparing a printed circuit board (PCB) or a flexible printed circuit board (FPCB) having multiple layers further repeatedly comprising a step of printing an insulating pattern and the steps 1) through 3).

5. The method according to Claim 1, of preparing a printed circuit board (PCB) or a flexible printed circuit board (FPCB) having both faces and conductive via-holes or through-holes further comprising a step of making holes in the substrate and the steps 1) through 3) on the other side of the substrate.

6. A printed circuit board (PCB) or a flexible printed circuit board (FPCB) having multiple layers prepared by the method according to Claim 4.

7. A printed circuit board (PCB) or a flexible printed circuit board (FPCB) having both faces and conductive via-holes or through-holes prepared by the method according to Claim 5.

8. A printed circuit board (PCB) or a flexible printed circuit board (FPCB) prepared by the method according to Claim 1.

9. The printed circuit board (PCB) or the flexible printed circuit board (FPCB) according to Claim 8, wherein the circuit in the printed circuit board (PCB) or the flexible printed circuit board (FPCB) is Rfid antenna
